(19) **Europäisches Patentamt European Patent Office Office européen des brevets**

(11) **EP 1 597 066 B1**

(12) **EUROPEAN PATENT SPECIFICATION**

(45) Date of publication and mention
of the grant of the patent:
**01.09.2010 Bulletin 2010/35**

(21) Application number: **04704386.4**

(22) Date of filing: **22.01.2004**

(51) Int Cl.:
*B32B 17/10* (2006.01)     *C03C 17/34* (2006.01)
*C23C 14/06* (2006.01)     *G02B 5/20* (2006.01)
*G02B 5/22* (2006.01)     *B05D 5/06* (2006.01)
*B23P 9/00* (2006.01)

(86) International application number:
**PCT/US2004/001526**

(87) International publication number:
**WO 2004/070072 (19.08.2004 Gazette 2004/34)**

(54) **HEAT TREATABLE COATED ARTICLE WITH CHROMIUM NITRIDE IR REFLECTING LAYER AND METHOD OF MAKING SAME**

WÄRMEBEHANDELBARER BESCHICHTETER ARTIKEL MIT CHROMNITRID-IR-REFLEXIONSSCHICHT UND DESSEN HERSTELLUNGSVERFAHREN

ARTICLE REVETU SUSCEPTIBLE D'ETRE TRAITE PAR LA CHALEUR AVEC UNE COUCHE REFLECHISSANTE A RAYONNEMENT INFRAROUGE EN NITRURE DE CHROMIUM ET SON PROCEDE DE FABRICATION

(84) Designated Contracting States:
**DE ES FR GB IT**

(30) Priority: **29.01.2003 US 353088**

(43) Date of publication of application:
**23.11.2005 Bulletin 2005/47**

(73) Proprietor: **GUARDIAN INDUSTRIES CORP.**
**Auburn Hills,**
**Michigan 48326-1714 (US)**

(72) Inventors:
• **STACHOWIAK, Grzegorz**
**Ann Arbor, MI 48108 (US)**

• **NEUMAN, George**
**Ann Arbor, MI 48108 (US)**
• **WANG, Hong**
**Belleville, MI 48111 (US)**

(74) Representative: **Hess, Peter K. G.**
**Patent- und Rechtsanwälte**
**Bardehle . Pagenberg . Dost .**
**Altenburg . Geissler**
**Postfach 86 06 20**
**81633 München (DE)**

(56) References cited:
WO-A-02/090281     WO-A-03/022770
WO-A-2005/024085     JP-A- 8 231 246
JP-A- 9 118 545     US-A- 5 543 229

**Description**

This invention relates to coated articles that include at least one chromium nitride infrared (IR) reflecting layer sandwiched between at least a pair of dielectric layers, and/or a method of making the same. Such coated articles may be used in the context of monolithic windows, insulating glass (IG) window units, laminated windows, and/or other suitable applications.

BACKGROUND OF THE INVENTION

The need for color matchability of coated articles (before heat treatment vs. after heat treatment) is known. Glass substrates are often produced in large quantities and cut to size in order to fulfill the needs of a particular situation such as a new multi-window and door office building, other window needs, etc. It is often desirable in such applications that some of the windows and/or doors be heat treated (i.e., tempered, heat strengthened or bent), while others need not be. Office buildings often employ IG units and/or laminates for safety and/or thermal control. It is often desirable that the units and/or laminates which are heat treated (HT) substantially match their non-heat treated counterparts (e.g., with regard to color, reflectance, and/or the like) for architectural and/or aesthetic purposes.

U.S. Patent No. 5,376,455 discloses a coated article including: glass/$Si_3N_4$NiCr/Ag/NiCr/$Si_3N_4$. Unfortunately, the coating system of the '455 patent is not sufficiently color matchable after heat treatment with its non-heat-treated counterpart. In other words, the coating system of the '455 patent has a rather high $\Delta E$ value. This means that, unfortunately, two different coated articles with different coatings (one to be heat treated, the other not to be) must be made for customers who want their heat-treated and non-heat-treated coated articles to approximately match colorwise as viewed by the naked eye.

As with the '455 patent, it has mostly been possible to achieve matchability only by providing two different layer systems, one of which is heat treated (HT) and the other is not. The necessity of developing and using two different layer systems to achieve matchability creates additional manufacturing expense and inventory needs which are undesirable.

However, commonly owned U.S. Patent No. 5,688,585 discloses a solar control coated article including glass/$Si_3N_4$/NiCr/$Si_3N_4$, wherein matchability is achieved with a single layer system. As explained at column 9 of the '585 patent, it is a "requirement" of the '585 invention that the NiCr layer be substantially free of any nitride. An object of the '585 patent is to provide a sputter coated layer system that after heat treatment is matchable colorwise with its non-heat-treated counterpart. However, the '585 patent uses a heat treatment (HT) of only three (3) minutes (col. 10, line 55). Longer heat treatments are often desired in order to attain better tempering or HT characteristics. Unfortunately, as explained below, it has been found that with longer HT times the coatings of the '585 patent cannot maintain low $\Delta E$ values and thus lose color matchability.

In document US 5,543,229 a large number of materials for sandwiching dielectric layers as well as for infrared reflecting layers are disclosed. Among others a layer sequence of silicon nitride/chromium nitride/silicon nitride is disclosed, however, no information is provided with regard to the atomic ratio of chromium and nitride in the IR-reflecting layer. ,

Consider the following layer stack: glass/$Si_3N_4$/NiCr/$Si_3N_4$, where the underlayer of $Si_3N_4$ is about 50-70 Å (angstroms) thick, the NiCr layer is about 325 Å thick (the NiCr layer is not nitrided as deposited as can be seen in Fig. 15), and the overcoat of $Si_3N_4$ is about 210-310 Å thick. It is noted that some amount of nitriding of the NiCr may possibly occur during heat treatment. Unfortunately, given the deposited NiCr layer, this coated article has a rather high transmissive $\Delta E^*$ value of about 5.9 after a heat treatment (HT) at 625 degrees C for ten (10) minutes. This high transmissive $\Delta E$ value means that a HT version of then '585 coated article does not approximately match colorwise non-heat-treated counterpart versions with regard to transmissive color after 10 minutes of HT. Moreover, such stacks have a glass side reflective $\Delta E^*$ value of above 5.0 after heat treatment (HT) at 625 degrees C for ten minutes. These high glass side reflective $\Delta E^*$ values are not desirable, and they prevent appearance matchability between HT and non-HT versions of the same coating.

Unfortunately, the layer stack of glass/$Si_3N_4$/NiCr/$Si_3N_4$, where the Ni/Cr ratio is 80/20, while providing efficient solar control and being overall good coatings, is also sometimes are lacking in terms of: (a) corrosion resistance to acid (e.g., HCl boil); and (b) mechanical performance such as scratch resistance; in addition to the problems described above associated with (c) thermal stability upon heat treatment for tempering, heat bending, or the like (i.e., $\Delta E^*$ value(s)).

Accordingly, there exists a need in the art for a coated article that has improved characteristics with respect to (a), (b) and/or (c) compared to a conventional layer stack of glass/$Si_3N_4$/NiCr/$Si_3N_4$, but which still is capable of acceptable solar control (e.g., blocking a reasonable amount of IR and/or UV radiation) and/or heat treatment. It is a purpose of this invention to fulfill at least one of the above-listed needs, and/or other needs which will become apparent to the skilled artisan once given the following disclosure.

SUMMARY OF THE INVENTION

According to this invention, a coating or layer system is provided which includes an infrared (IR) reflecting layer comprising chromium nitride sandwiched between at least a pair of dielectric layers. The coating or layer system has good corrosion resistance to acid(s) such as HCl, good mechanical performance such as scratch resistance, and/or good color stability (i.e., a low $\Delta E^*$ value(s)) upon heat treatment (HT).

For example, a coating or layer system including an IR reflecting layer comprising chromium nitride has been found to have better durability (e.g., with respect to acid exposure) than the aforesaid conventional coating including a NiCr IR reflecting layer. Moreover, it has surprisingly been found that the use of chromium nitride as an IR reflecting layer enables a solar control coating to have significantly improved stability upon HT (e.g., a lower $\Delta E^*$ value with a given HT time) than the aforesaid conventional coating where metallic NiCr is used as the IR reflecting layer.

This invention utilizes such a chromium nitride layer sandwiched between a pair of silicon nitride dielectric layers.

Coated articles according to certain embodiments of this invention may be used as monolithic windows due to their excellent durability characteristics, which may or may not be heat treated. Alternatively, coated articles according to this invention may also be used in the context of insulating glass (IG) window units, or in other suitable application, which may or may not involve heat treatment.

According to this invention, heat treated (HT) coated articles including a chromium nitride IR reflecting layer have a $\Delta E^*$ value (glass side reflective and/or transmissive) of no greater than 3.0, even more preferably no greater than 2.5, still even more preferably no greater than 2.0, and most preferably no greater than 1.8. For purposes of example, the heat treatment (HT) may be for at least about 5 minutes at a temperature(s) of at least about 580 degrees C, and may be at a temperature of at least about 600 degrees C for a period of time of at least 5 minutes (more preferably at least 7 minutes, and most preferably at least 9 minutes) in certain example embodiments.

According to this invention, the IR reflecting layer which is sandwiched between at least a pair of dielectric layers comprises, consists essentially of, or consists of chromium nitride. The chromium nitride IR reflecting layer is represented by $Cr_xN_y$, where the y/x ratio is from 0.25 to 0.7, even more preferably from 0.3 to 0.6, still more preferably from 0.45 to 0.55. For purposes of example only, $Cr_2N$ translates into a y/x ratio of 1/2 (i.e., 0.5). It has surprisingly been found that these particular y/x ratio range(s) for nitrides of chromium(Cr) are particularly beneficial with respect to thermal, optical and/or durability characteristics. For instance, nitriding of Cr in amounts greater than this may result in less durability (e.g., mechanical and/or chemical resistance).

According to this invention, one or more of the above-listed needs is/are fulfilled by providing a method of making a coated article, the method comprising: sputtering a first dielectric layer on a substrate; sputtering a layer comprising chromium nitride on the substrate over the first dielectric layer; sputtering a second dielectric layer on the substrate over the layer comprising chromium nitride; and wherein the layer comprising chromium nitride is sputtered so as to form $Cr_xN_y$ where y/x is from 0.3 to 0.7.

IN THE DRAWINGS

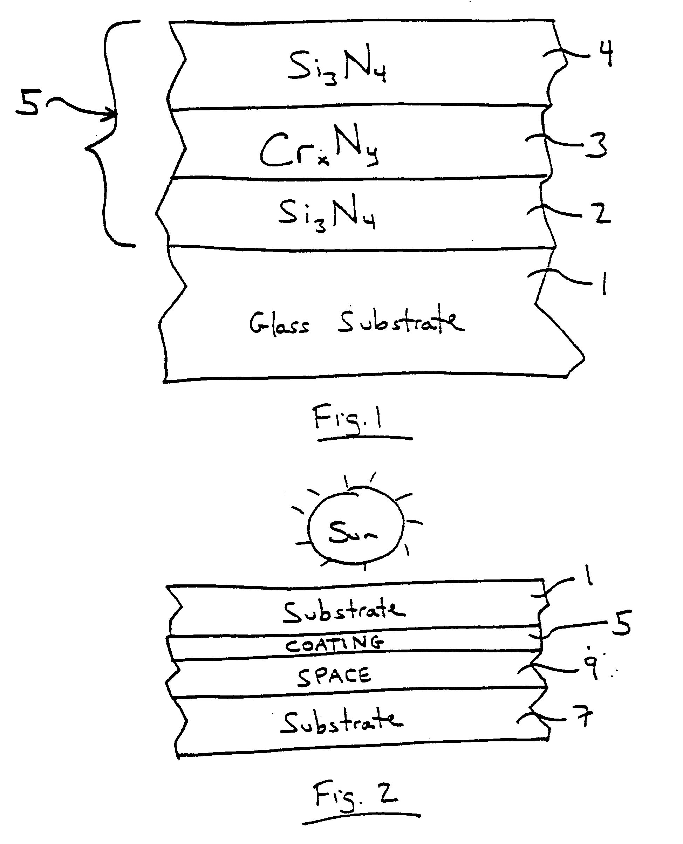

Fig. 1 is a partial cross sectional view of an embodiment of a monolithic coated article (heat treated or not heat treated) according to an example embodiment of this invention.

Fig. 2 is a partial cross-sectional view of an IG window unit as contemplated by this invention, in which the coating or layer system of Fig. 1 may be used.

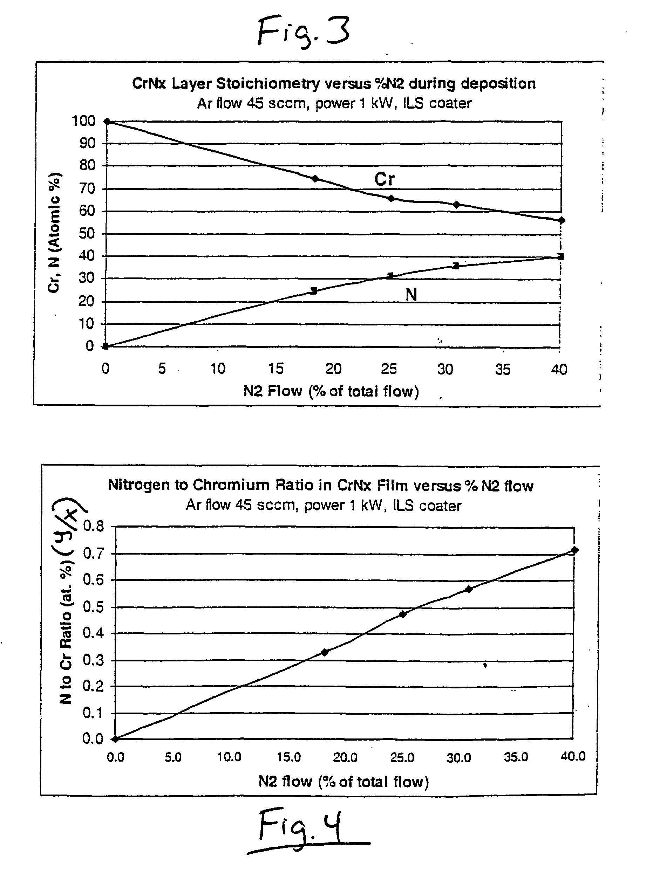

Fig. 3 is a graph plotting nitrogen gas flow as a % of total gas flow during sputtering of a chromium nitride layer vs. Cr, N atomic content in the resulting layer, illustrating stoichiometry of chromium nitride layers according to different embodiments of this invention as a function of nitrogen gas flow during sputtering (N and Cr atomic percentages were determined using XPS).

Fig. 4 is a graph plotting nitrogen gas flow as a percentage of total gas flow during sputtering of a chromium nitride layer vs. the resulting ratio y/x (given $Cr_xN_y$) in the resulting chromium nitride layer according to different embodiments of this invention, thereby illustrating different stoichiometries of the layer as a function of the amount of nitrogen in the total sputtering gas flow (N and Cr atomic percentages were determined using XPS).

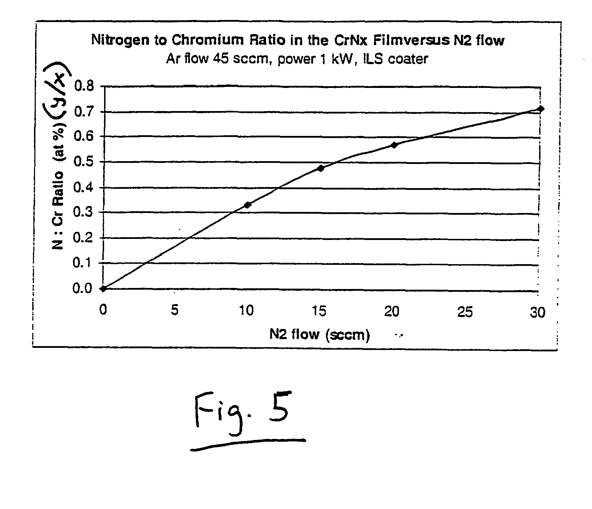

Fig. 5 is a graph plotting nitrogen gas flow (in units of sccm) during sputtering of a chromium nitride layer vs. the resulting ratio y/x (given $Cr_xN_y$) in the resulting chromium nitride layer according to different embodiments of this invention, thereby illustrating different stoichiometries of the layer as a function of nitrogen gas flow during sputtering (N and Cr atomic percentages were determined using XPS).

DETAILED DESCRIPTION OF CERTAIN EXAMPLE EMBODIMENTS OF THE INVENTION

Certain embodiments of this invention provide a coating or layer system that may be used in windows such as monolithic windows (e.g., vehicle, residential, or architectural windows), IG window units, and/or other suitable applications. This invention provides a layer system that is characterized by good (a) corrosion resistance to acid (e.g., which can be tested via an HCl boil); (b) mechanical performance such as scratch resistance; and/or (c) thermal stability upon heat treatment. With respect to thermal stability upon heat treatment (HT), this means a low value of $\Delta E^*$ (glass side reflective and/or transmissive); where $\Delta$ is indicative of change in view of HT such as thermal tempering, heat bending, or thermal heat strengthening, monolithically and/or in the context of dual pane environments such as IG units or laminates. Such heat treatments sometimes necessitate heating the coated substrate to temperatures from about 580˚C up to about 800˚C for 4-5 minutes or more, and in certain embodiments at a temperature(s) of at least about an oven setting of 600 degrees C for a period of time of at least 4 or 5 minutes (more preferably at least 7 minutes, and most preferably at least 9 minutes) in certain example embodiments.

Figure 1 is a side cross sectional view of a coated article according to an example embodiment of this invention. The coated article includes at least substrate 1 (e.g., clear, green, bronze, grey, blue, or blue-green glass substrate from about 1.0 to 12.0 mm thick), first dielectric layer 2 including silicon nitride (e.g., $Si_3N_4$), infrared (IR) reflecting layer 3 comprising, consisting essentially of, or consisting of chromium nitride ($Cr_xN_y$), and second dielectric layer 4 including silicon nitride (e.g., $Si_3N_4$). In certain example embodiments of this invention, coating 5 does not include any metallic IR reflecting layer such as Ag or Au. In such embodiments, chromium nitride IR reflecting layer 3 may be the only IR reflecting layer in coating 5.

According to this invention, IR reflecting layer 3 is substantially free of Ni (i.e., contains no more than about 10 % Ni, more preferably no more than 5% Ni, even more preferably no more than 1% Ni, and most preferably no more than 0.01 % Ni).

Overall coating 5 includes at least layers 2-4. It is noted that the terms "oxide" and "nitride" as used herein include various stoichiometries. For example, the term silicon nitride includes stoichiometric $Si_3N_4$, as well as non-stoichiometric silicon nitride such as Si-rich silicon nitride. Layers 2-4 may be deposited on substrate 1 via magnetron sputtering, or via any other suitable technique in different embodiments of this invention.

In certain example embodiments of this invention, IR reflecting layer 3 is sputter-deposited as chromium nitride. The stoichiometry of this layer as deposited may be represented, in certain example embodiments, by $Cr_xN_y$, where the ratio y/x (i.e., the ratio of N to Cr) is from 0.25 to 0.7, even more preferably from 0.3 to 0.6, still more preferably from 0.45 to 0.55. For purposes of example only, chromium nitride in the form of $Cr_2N$ translates into a y/x ratio of 1/2 (i.e., 0.5). It has surprisingly been found that the aforesaid y/x ratio ranges for nitrides of chromium are particularly beneficial with respect to coating characteristics such as durability and optical performance. For instances, nitriding of Cr in amounts greater than this (approaching CrN where y/x = 1) may result in less chemical resistance of coating 5 and/or poor adhesion to silicon nitride especially after HT. In other words, if the y/x ratio is greater than the aforesaid range(s), durability degrades in certain instances.

Other layer(s) may be provided between substrate 1 and layer 2 in certain embodiments of this invention; and/or other layer(s) may be provided on substrate 1 over layer 4 in certain embodiments of this invention. The terms "on" and "supported by" as used herein are not limited to directly contacting.

Surprisingly, it has been found that the use of $Cr_xN_y$ in layer 3 (as opposed to NiCr) results in a coated article having: (a) improved corrosion resistance with respect to acid such as HCl; (b) improved mechanical durability; and (c) improved color stability upon heat treatment (i.e., lower $\Delta E^*$ value(s)).

In certain example embodiments of this invention, dielectric antireflection layers 2 and/or 4 each may have an index of refraction "n" of from about 1.5 to 2.5, more preferably from 1.9 to 2.3. In embodiments of this invention T layers 2 and 4 comprise silicon nitride (e.g., $Si_3N_4$). Sputtering targets including Si employed to form these layers may or may not be admixed with up to 6-20% by weight aluminum and/or stainless steel (e.g. SS#316), with about this amount then appearing in the layers so formed.

While Fig. 1 illustrates a coated article according to an embodiment of this invention in monolithic form, Fig. 2 illustrates the coating or layer system 5 of Fig. 1 being utilized on surface #2 of an IG (insulating glass) window unit. In Fig. 2, the two glass substrates (e.g., float glass 2 mm to 12 mm thick) 1, 7 are sealed at their peripheral edges by a conventional sealant and/or spacer (not shown) and may be provided with a conventional desiccant strip (not shown). The panes are then retained in a conventional window or door retaining frame. By sealing the peripheral edges of the glass sheets and replacing the air in insulating space (or chamber) 9 with a gas such as argon, a high insulating value IG unit is formed as illustrated in Fig. 2. Optionally, insulating space 9 may be at a pressure less than atmospheric pressure in certain alternative embodiments, although this of course is not necessary in all IG embodiments. In IG embodiments, coating 5 from Fig. 1 may be provided on the inner wall of substrate 1 in certain embodiments of this invention (as in Fig. 2), and/or on the inner wall of substrate 7 in other embodiments of this invention.

Turning back to Fig. 1, while various thicknesses may be used consistent with one or more of the objects and/or needs discussed herein. According to certain non-limiting example embodiments of this invention, example thicknesses and materials for the respective layers on the glass substrate 1 are as follows:

Table 1 (Example non-limiting thicknesses)

| Layer | Example Range (Å) | Preferred (Å) | Best (Å) |
|---|---|---|---|
| silicon nitride (layer 2): | 10-1,200 Å | 20-1,000 Å | 50-900 Å |
| $Cr_xN_y$ (layer 3): | 50-700 Å | 100-500 Å | 100-300 Å |
| silicon nitride (layer 4): | 50-900 Å | 100-500 Å | 200-400 Å |

In certain exemplary embodiments, the color stability with HT may result in substantial matchability between heat-treated and non-heat treated versions of the coating or layer system. In other words, in monolithic and/or IG applications, in certain embodiments of this invention two glass substrates having the same coating system thereon (one HT after deposition and the other not HT) appear to the naked human eye to look substantially the same. Stated yet another way, the coated article has good color stability upon HT.

The value(s) $\Delta E^*$ is important in determining whether or not there is matchability, or substantial color matchability upon HT, in the context of certain embodiments of this invention (i.e., the term $\Delta E^*$ is important in determining color stability upon HT). Color herein is described by reference to the conventional $a^*$, $b^*$ values. For example, the term $\Delta a^*$ is indicative of how much color value $a^*$ changes due to HT.

The term $\Delta E^*$ (and $\Delta E$) is well understood in the art and is reported, along with various techniques for determining it, in ASTM 2244-93 as well as being reported in Hunter et. al., The Measurement of Appearance, 2nd Ed. Cptr. 9, page 162 et seq. (John Wiley & Sons, 1987). As used in the art, $\Delta E^*$ (and $\Delta E$) is a way of adequately expressing the change (or lack thereof) in reflectance and/or transmittance (and thus color appearance, as well) in an article after or due to HT. $\Delta E$ may be calculated by the "ab" technique, or by the Hunter technique (designated by employing a subscript "H"). $\Delta E$ corresponds to the Hunter Lab L, a, b scale (or $L_h$, $a_h$, $b_h$). Similarly, $\Delta E^*$ corresponds to the CIE LAB Scale $L^*$, $a^*$, $b^*$. Both are deemed useful, and equivalent for the purposes of this invention. For example, as reported in Hunter et. al. referenced above, the rectangular coordinate/scale technique (CIE LAB 1976) known as the $L^*$, $a^*$, $b^*$ scale may be used, wherein:

$L^*$ is (CIE 1976) lightness units

$a^*$ is (CIE 1976) red-green units

$b^*$ is (CIE 1976) yellow-blue units

and the distance $\Delta E^*$ between $L^*_o$ $a^*_o$ $b^*_o$ and $L^*_1$ $a^*_1$ $b^*_1$ is:

$$\Delta E^* = \{(\Delta L^*)^2 + (\Delta a^*)^2 + (\Delta b^*)^2\}^{1/2} \qquad (1)$$

where:

$$\Delta L^* = L^*_1 - L^*_o \qquad (2)$$

$$\Delta a^* = a^*_1 - a^*_o \qquad (3)$$

$$\Delta b^* = b^*_1 - b^*_o \qquad (4)$$

where the subscript "o" represents the coating (or coated article) before heat treatment and the subscript "1" represents the coating (or coated article) after heat treatment; and the numbers employed (e.g., $a^*$, $b^*$, $L^*$) are those calculated by the aforesaid (CIE LAB 1976) $L^*$, $a^*$, $b^*$ coordinate technique. In a similar manner, $\Delta E$ may be calculated using equation (1) by replacing a*, b*, L* with Hunter Lab values $a_h$, $b_h$, $L_h$. Also within the scope of this invention and the quantification of $\Delta E^*$ are the equivalent numbers if converted to those calculated by any other technique employing the same concept of $\Delta E^*$ as defined above.

After heat treatment (HT) such as thermal tempering, in certain example embodiments of this invention coated articles have color characteristics as follows in Table 2. It is noted that subscript "G" stands for glass side reflective color, subscript "T" stands for transmissive color, and subscript "F" stands for film side color. As is known in the art, glass side (G) means reflective color when viewed from the glass side (as opposed to the layer/film side) of the coated article. Film side (F) (not shown in Table 2) means reflective color when viewed from the side of the coated article on which the coating 5 is provided.

Table 2: Color/Optical Characteristics due to/after Heat Treatment

|  | General | Preferred | Most Preferred |
| --- | --- | --- | --- |
| $\Delta E^*_G$ | <= 5.0 | <= 4.0 | <= 3.0 |
| $\Delta E^*_T$ | <= 5.0 | <= 4.0 | <= 3.0 |
| $a^*_G$ | -6 to +6 | -4 to +4 | -3 to +3 |
| $b^*_G$ | -30 to +25 | -25 to +20 | -20 to +10 |
| $\Delta a^*_G$ | <= 1.0 | <= 0.7 | <= 0.5 |
| $\Delta b^*_G$ | <= 1.5 | <= 0.8 | <= 0.5 |
| $\Delta L^*_G$ | <= 5 | <= 3 | <= 2 |
| $T_{vis}$ (TY): | 8-80% | 10-50% | 10-30% |
| $R_s$ ($\Omega$/sq): | < 250 | < 150 | < 110 |

Coated articles after HT herein may even have a $\Delta E^*$ value(s) (glass side reflective and/or transmissive) of no greater than 2.5, more preferably no greater than 2.0, and sometimes even no greater than 1.8 in certain example embodiments of this invention. In certain example embodiments, coated articles after HT herein may even have a $\Delta E^*$ value(s) (glass side reflective and/or transmissive) of no greater than 1.5, or even 1.2.

Figs. 3-5 illustrate various stoichiometries of chromium nitride layer 3 according to different embodiments of this invention. In particular, these figures illustrate various ratios of N to Cr (ratios y/x) in the chromium nitride layer 3 as a function of nitrogen gas flow during the sputtering process in which the layer 3 is sputter-deposited. In these figures, the N and Cr atomic percentages (at. %) were determined using XPS. Additionally, it is noted that the correlation between nitrogen gas flows and the N to Cr ratio(s) was determined in accordance with the ILS coater used to deposit these samples since the flows were measured in this sputter coater.

Fig. 3 is a graph plotting, during sputtering of a chromium nitride layer, nitrogen gas flow as a percentage of total gas flow (e.g., where Ar and N gases were used) vs. Cr, N atomic content in the resulting layer 3, illustrating stoichiometry of chromium nitride layers according to different embodiments of this,invention as a function of nitrogen gas flow. Fig. 4 is a graph plotting nitrogen gas flow as a percentage of total gas flow during sputtering of a chromium nitride layer vs. the resulting ratio y/x (given $Cr_xN_y$) in the resulting chromium nitride layer according to different embodiments of this invention, thereby illustrating different stoichiometries of the layer as a function of the amount of nitrogen in the total sputtering gas flow. Fig. 5 is a graph plotting nitrogen gas flow (in units of sccm) during sputtering of a chromium nitride layer vs. the resulting ratio y/x (given $Cr_xN_y$) in the resulting chromium nitride layer according to different embodiments of this invention, thereby illustrating different stoichiometries of the layer as a function of nitrogen gas flow during sputtering.

As explained above, the best performance (balancing durability and solar performance) surprisingly occurs when the $Cr_xN_y$ layer 3 is characterized by a N to Cr ratio y/x of from 0.25 to 0.7 (even 0.25 to 0.9 in some instances), even more preferably from 0.3 to 0.6, still more preferably from 0.45 to 0.55.

For purposes of example only, a plurality of examples representing different example embodiments of this invention are set forth below.

EXAMPLES 1-2

Examples 1-2 were monolithic coated articles (each ultimately annealed and heat treated). The $Si_3N_4$ layers 2 and 4 in each example were deposited by sputtering a silicon target (doped with about 10% Al) in an atmosphere including nitrogen gas. The chromium nitride layer 3 in each example was deposited by sputtering in an atmosphere including argon and nitrogen gas.

For Example 1, the following sputtering process parameters were used in depositing the coating. Line speed is in inches per minute (IPM), and gas (Ar and N) flows were in units of sccm:

TABLE 3: Example 1 Coating Process Parameters

| Layer | Power | Voltage | Line Speed | # Passes | Ar flow | N flow |
|---|---|---|---|---|---|---|
| SiN layer 2: | 1.0 kW | 463 V | 41.2 | 2 | 40 | 40 |
| $Cr_xN_y$ layer 3: | 1.0 kW | 392 V | 41.5 | 2 | 45 | 15 |
| SiN layer 4: | 1.0 kW | 462 V | 41.2 | 7 | 40 | 40 |

For Example 2, the following sputtering process parameters were used in depositing the coating. Again, line speed is in inches per minute (IPM), and gas flows were in units of sccm:

TABLE 4: Example 2 Coating Process Parameters

| Layer | Power | Voltage | Line Speed | # Passes | Ar flow | N flow |
|---|---|---|---|---|---|---|
| SiN layer 2: | 2.5 kW | 501 V | 44.5 | 8 | 40 | 55 |
| $Cr_xN_y$ layer 3: | 1.0 kW | 393 V | 38.1 | 2 | 45 | 15 |
| SiN layer 4: | 2.5 kW | 502 V | 41.3 | 2 | 40 | 55 |

After being sputtered, Examples 1-2 had the following characteristics after being sputtered (annealed and non-HT) (Ill. C, 2 degree observer):

TABLE 5: Characteristics (non- HT)

| Parameter | Ex. 1 | Ex. 2 |
|---|---|---|
| $T_{vis}$ (TY)(transmissive): | 22.5% | 20.9% |
| $a^*_T$ | -0.9 | -1.1 |
| $b^*_T$ | -4.6 | 2.4 |
| $L^*_T$ | 54.5 | 52.8 |
| $R_GY$(glass side refl. %): | 31.5% | 18.5% |
| $a^*_G$: | -2.2 | -1.1 |
| $b^*_G$: | -4.2 | -19.0 |
| $L^*_G$: | 62.9 | 50.1 |
| $R_FY$ (film side refl. %): | 20.7% | 34.7% |
| $a^*_F$: | 0.3 | 0.1 |
| $b^*_F$: | 24.4 | 17.6 |
| $L^*_F$: | 52.6 | 65.5 |
| $T_{sol}$ (TS): | 18% | 18% |
| Shading Coefficient (SC): | 0.39 | 0.41 |
| SHGC: | 0.33 | 0.35 |
| $T_{uv}$ (UV transmission): | 20.3% | 16.0% |
| $R_s$ (sheet resistance; ohms/sq.): | 86.4 | n/a |

Each of Examples 1 and 2 had a layer stack as follows, set forth in Table 6. The thicknesses and stoichiometries listed below in Table 6 for the Examples 1-2 are approximations and are not exact. The coating 5 for each Example is shown in Fig. 1, and thus includes layers 2, 3 and 4. The glass substrates were clear and about 6 mm thick in each Example.

TABLE 6: Coatings in Examples

| | |
|---|---|
| Example 1: | Glass/$Si_3N_4$(100 Å)/$Cr_xN_y$(170 Å)/$Si_3N_4$(350 Å) |
| Example 2: | Glass/$Si_3N_4$(890 Å)/$Cr_xN_y$(185 Å)/$Si_3N_4$(240 Å) |

After being sputter coated, each of Examples 1 and 2 was then heat treated for 10 minutes at about 625 degrees C. Table 7 below sets forth certain color stability characteristics of Examples 1-2 upon/after heat treatment (HT).

TABLE 7: Glass Side Refl. Color Stability Upon HT

| Parameter | Ex. 1 | Ex. 2 |
|-----------|-------|-------|
| $\Delta E^*_G$: | 0.8 | 1.7 |

As can be seen from Table 7, Examples 1-2 were characterized by excellent glass side reflective $\Delta E^*$ values. The low numbers associated with these values illustrate how little the optical characteristics of the coating changed upon the heat treatment. This is indicative of superior stability upon heat treatment (e.g., thermal tempering or the like).

For purposes of comparison, consider the following layer stack: glass/$Si_3N_4$/NiCr/ $Si_3N_4$, which has a glass side reflective $\Delta E^*$ value of above 5.0 after heat treatment (HT) at 625 degrees C for ten minutes. The Examples 1-2 above clearly illustrate the comparative advantage of using chromium nitride, as opposed to NiCr, for the IR reflecting layer. A much lower glass side reflective $\Delta E^*$ value is achievable using chromium nitride. Moreover, durability may also be improved as explained above.

Reference EXAMPLES 3-5

As mentioned above, it has surprisingly been found that given $Cr_xN_y$ in layer 3, a ratio y/x (i.e., the ratio of N to Cr) of from 0.25 to 0.9, even more preferably from 0.3 to 0.7, still more preferably from 0.3 to 0.6, is superior to other ratios with respect to durability and optical characteristics. Examples 3-5 set forth below illustrate how different $Cr_xN_y$ layers 3 were made in a sputter coater (by sputtering) according to different embodiments of this invention, in various manner which kept the ratio y/x within the range of from 0.25 to 0.9. Examples 3-5 were each sputtered onto 3mm clear glass substrates, with no silicon nitride layers thereon. The atomic percentages were measured in the resulting chromium nitride layers from the examples via XPS, as was the ratio y/x (given $Cr_xN_y$).

TABLE 8: Sputtering of Examples 3-5

| Characteristic | Example 3 | Example 4 | Example 5 |
|----------------|-----------|-----------|-----------|
| Material: | $Cr_xN_y$ | $Cr_xN_y$ | $Cr_xN_y$ |
| Power (kW): | 1 | 1 | 1 |
| U (V): | 397 | 399 | 402 |
| Pressure (mTorr): | 1.8 | 2.0 | 2.4 |
| Ar flow (sccm): | 45 | 45 | 45 |
| N flow (sccm): | 10 | 20 | 30 |
| % N flow (N/N+Ar): | 18.2 | 30.8 | 40.0 |
| Cr atomic %: | 74.4 | 62.8 | 56.2 |
| N atomic %: | 24.5 | 35.8 | 40.2 |
| Ratio y/x: | 0.33 | 0.57 | 0.72 |

It can be seen from Table 8 above numerous ways in which to sputter deposit chromium nitride in a manner such that the y/x ratio of N to Cr is in the desired range.

Accordingly, advantages associated with the use of chromium nitride as a IR reflecting layer include (a) improved corrosion resistance with respect to acid such as HCl; (b) improved mechanical performance such as better scratch resistance; and/or (c) improved thermal stability (i.e., lower $\Delta E^*$ value(s)). In certain embodiments of this invention, coated articles may or may not be heat treated.

Certain terms are prevalently used in the glass coating art, particularly when defining the properties and solar management characteristics of coated glass. Such terms are used herein in accordance with their well known meaning. For example, as used herein:

Intensity of reflected visible wavelength light, i.e. "reflectance" is defined by its percentage and is reported as $R_xY$ (i.e. the Y value cited below in ASTM E-308-85), wherein "X" is either "G" for glass side or "F" for film side. "Glass side" (e.g. "G") means, as viewed from the side of the glass substrate opposite that on which the coating resides, while "film side" (i.e. "F") means, as viewed from the side of the glass substrate on which the coating resides.

Color characteristics are measured and reported herein using the CIE LAB a*, b* coordinates and scale (i.e. the CIE a*b* diagram, Ill. CIE-C, 2 degree observer). Other similar coordinates may be equivalently used such as by the subscript "h" to signify the conventional use of the Hunter Lab Scale, or Ill. CIE-C, $10^0$ observer, or the CIE LUV u*v* coordinates. These scales are defined herein according to ASTM D-2244-93 "Standard Test Method for Calculation of Color Differences From Instrumentally Measured Color Coordinates" 9/15/93 as augmented by ASTM E-308-85, Annual Book of ASTM Standards, Vol. 06.01 "Standard Method for Computing the Colors of Objects by 10 Using the CIE System" and/or as reported in IES LIGHTING HANDBOOK 1981 Reference Volume.

The terms "emittance" and "transmittance" are well understood in the art and are used herein according to their well known meaning. Thus, for example, the terms visible light transmittance (TY), infrared radiation transmittance, and ultraviolet radiation transmittance ($T_{uv}$) are known in the art. Total solar energy transmittance (TS) is then usually characterized as a weighted average of these values from 300 to 2500 nm (UV, visible and near IR). With respect to these transmittances, visible transmittance (TY), as reported herein, is characterized by the standard CIE Illuminant C, 2 degree observer, technique at 380 - 720 nm; near-infrared is 720 - 2500 nm; ultraviolet is 300 - 380 nm; and total solar is 300 - 2500 nm. For purposes of emittance, however, a particular infrared range (i.e. 2.500 - 40,000 nm) is employed.

Visible transmittance can be measured using known, conventional techniques. For example, by using a spectrophotometer, such as a Perkin Elmer Lambda 900 or Hitachi U4001, a spectral curve of transmission is obtained. Visible transmission is then calculated using the aforesaid ASTM 308/2244-93 methodology. A lesser number of wavelength points may be employed than prescribed, if desired. Another technique for measuring visible transmittance is to employ a spectrometer such as a commercially available Spectrogard spectrophotometer manufactured by Pacific Scientific Corporation. This device measures and reports visible transmittance directly. As reported and measured herein, visible transmittance (i.e. the Y value in the CIE tristimulus system, ASTM E-308-85) uses the Ill. C.,2 degree observer.

Another term employed herein is "sheet resistance". Sheet resistance ($R_s$) is a well known term in the art and is used herein in accordance with its well known meaning. It is here reported in ohms per square units. Generally speaking, this term refers to the resistance in ohms for any square of a layer system on a glass substrate to an electric current passed through the layer system. Sheet resistance is an indication of how well the layer or layer system is reflecting infrared energy, and is thus often used along with emittance as a measure of this characteristic. "Sheet resistance" may for example be conveniently measured by using a 4-point probe ohmmeter, such as a dispensable 4-point resistivity probe with a Magnetron Instruments Corp. head, Model M-800 produced by Signatone Corp. of Santa Clara, California.

"Chemical durability" or "chemically durable" is used herein synonymously with the term of art "chemically resistant" or "chemical stability". For example, chemical durability may be determined by boiling a sample of a coated glass substrate in about 500 cc of 5% HCl for one hour (i.e. at about 195˚F). Alternatively, chemical durability may be determined by an NaOH boil which includes boiling a sample of a coated glass substrate in a solution having a pH of about 12.2 that is a mixture of water and NaOH (about 0.4% NaOH); the solution is available from LabChem, Inc., Cat. No. LC 24270-4 (this is what is meant by NaOH boil herein). The NaOH boil may be carried out at a temperature of about 145 degrees F (Examples above), or about 195 degrees F in other instances.

The terms "heat treatment" and "heat treating" as used herein mean heating the article to a temperature sufficient to enabling thermal tempering, bending, and/or heat strengthening of the glass inclusive article. This definition includes, for example, heating a coated article to a temperature of at least about 580 or 600 degrees C for a sufficient period to enable tempering. In some instances, the HT may be for at least about 4 or 5 minutes.

Once given the above disclosure many other features, modifications and improvements will become apparent to the skilled artisan. Such other features, modifications and improvements are therefore considered to be a part of this invention, the scope of which is to be determined by the following claims:

## Claims

1. A heat treated coated article including a layer system (5) supported by a glass substrate (1), the layer system comprising:

    a first layer (2) comprising silicon nitride;
    a layer comprising chromium nitride (3) provided on the glass substrate (1) over the first layer (2) comprising silicon nitride;
    a second layer (4) comprising silicon nitride provided on the glass substrate (1) over the layer comprising chromium nitride (3);
    wherein the layer comprising chromium nitride (3) is sandwiched between and contacts each of the first (2) and second (4) layers comprising silicon nitride; and
    wherein the coated article has a ΔE* value (glass side reflective) of no greater than 3.0 after and/or due to heat treatment; and
    wherein the layer comprising chromium nitride is represented by $Cr_xN_y$,
    where a ratio y/x ofN to Cr is from 0.25 to 0.7 and contains no more than about 10% Ni.

2. The coated article of claim 1, wherein the coated article has a ΔE* value (glass side reflective) of no greater than 2.0 after and/or due to heat treatment.

3. The coated article of claim 1, wherein the layer system (5) consists essentially of the first (2) and second (4) layers comprising silicon nitride and the layer comprising chromium nitride (3).

4. The coated article of claim 1, wherein the coated article has no metallic infrared (IR) reflecting layer.

5. The coated article of claim 1, wherein the layer comprising chromium nitride (3) does not contact any metal layer.

6. The coated article of claim 1, wherein the layer comprising chromium nitride (3) is formed so that it is nitrided as deposited.

7. The coated article of claim 1, wherein the coated article is an IG window unit, a monolithic window, or a laminated window.

8. The coated article of claim 1, wherein said chromium nitride is **characterized by** $Cr_xN_y$, where y/x is from 0.3 to 0.6.

9. The coated article of claim 1, wherein said chromium nitride is **characterized by** $Cr_xN_y$, where y/x is from 0.45 to 0.55.

10. The coated article of claim 1, wherein said layer comprising chromium nitride (3) includes from about 55 to 90 atomic % chromium, and from about 15 to 50 atomic % nitrogen.

11. A method of making a coated article, the method comprising:

   sputtering a first dielectric layer of silicon nitride on a substrate;
   sputtering a layer comprising chromium nitride on the substrate over the first dielectric layer;
   sputtering a second dielectric layer of silicon nitride on the substrate over the layer comprising chromium nitride; and
   wherein the layer comprising chromium nitride is sputtered so as to form $Cr_xN_y$ where y/x is from 0.25 to 0.7 and contains no more than about 10% Ni.

12. The method of claim 11, further comprising heat treating the coated article at a temperature (s) of at least 580-600 degrees C, so that the coated article has a $\Delta E^*$ value (glass side reflective and/or transmissive) of no greater than 3.0 due to the heat treating.

**Patentansprüche**

1. Ein wärmebehandelter beschichteter Gegenstand umfassend ein Schichtsystem (5) getragen von einem Glassubstrat (1), wobei das Schichtsystem umfasst:

   eine erste Schicht (2) umfassend Siliziumnitrid;
   eine Schicht umfassend Chromiumnitrid (3) auf dem Glassubstrat (1) über der ersten Schicht (2) umfassend Siliziumnitrid;
   eine zweite Schicht (4) umfassend Siliziumnitrid auf dem Glassubstrat (1) über der Schicht umfassend Chromiumnitrid (3);
   wobei die Schicht umfassend Chromiumnitrid (3) sandwichartig zwischen und in Kontakt mit jeder der ersten (2) und zweiten (4) Schichten umfassend Siliziumnitrid angeordnet ist; und
   wobei der beschichtete Gegenstand einen $\Delta E^*$ Wert (glasseitige Reflexion) von nicht mehr als 3,0 nach und/oder aufgrund einer Wärmebehandlung hat; und
   wobei die Schicht umfassend Chromiumnitrid durch $Cr_xN_y$ repräsentiert wird, wobei ein Verhältnis y/x von N zu Cr von 0,25 bis 0,7 ist, und nicht mehr als etwa 10% Ni enthält.

2. Der beschichtete Gegenstand nach Anspruch 1, wobei der beschichtete Gegenstand einen $\Delta E^*$ Wert (glasseitige Reflexion) von nicht mehr als 2,0 nach und/oder aufgrund einer Wärmebehandlung hat.

3. Der beschichtete Gegenstand nach Anspruch 1, wobei das Schichtsystem (5) im Wesentlichen aus den ersten (2) und zweiten (4) Schichten umfassend Siliziumnitrid und der Schicht umfassend Chromiumnitrid (3) besteht.

4. Der beschichtete Gegenstand nach Anspruch 1, wobei der beschichtete Gegenstand keine metallische Infrarot (IR) reflektierende Schicht aufweist.

**5.** Der beschichtete Gegenstand nach Anspruch 1, wobei die Schicht umfassend Chromiumnitrid (3) keine metallische Schicht kontaktiert.

**6.** Der beschichtete Gegenstand nach Anspruch 1, wobei die Schicht umfassend Chromiumnitrid (3) so gebildet wird, dass sie wie abgelagert nitriert ist.

**7.** Der beschichtete Gegenstand nach Anspruch 1, wobei der beschichtete Gegenstand eine Isolierglasfenstereinheit ist, ein einfaches Fenster, oder ein laminiertes Fenster.

**8.** Der beschichtete Gegenstand nach Anspruch 1, wobei das Chromiumnitrid charakterisiert wird durch $Cr_xN_y$, wobei y/x von 0,3 bis 0,6 ist.

**9.** Der beschichtete Gegenstand nach Anspruch 1, wobei das Chromiumnitrid charakterisiert ist durch $Cr_xN_y$, wobei y/x von 0,45 bis 0,55 ist.

**10.** Der beschichtete Gegenstand nach Anspruch 1, wobei die Schicht umfassend Chromiumnitrid (3) von etwa 55 bis 90 Atomprozent Chrom umfasst und von etwa 15 bis 50 Atomprozent Stickstoff.

**11.** Ein Verfahren zur Herstellung eines beschichteten Gegenstands, welches Verfahren die folgenden Schritte umfasst:

Sputtern einer ersten dielektrischen Schicht von Siliziumnitrid auf ein Substrat;
Sputtern einer Schicht umfassend Chromiumnitrid auf das Substrat über der ersten dielektrischen Schicht;
Sputtern einer zweiten dielektrischen Schicht von Siliziumnitrid auf das Substrat über der Schicht umfassend Chromiumnitrid; und
wobei die Schicht umfassend Chromiumnitrid gesputtert wird, um $Cr_xN_y$ zu formen, wobei y/x von 0,25 bis 0,7 ist und nicht mehr als etwa 10% Ni enthält.

**12.** Das Verfahren nach Anspruch 11, weiter umfassend das wärmebehandeln des beschichteten Gegenstands bei einer Temperatur von zumindest 580 - 600 Grad Celsius, so dass der beschichtete Gegenstand einen $\Delta E^*$ Wert (glasseitige Reflexion und/oder transmissiv) von nicht mehr als 3,0 aufgrund der Wärmebehandlung aufweist.

**Revendications**

**1.** Un article revêtu traité thermiquement, comprenant un système de couches (5) supporté par un substrat de verre (1), le système de couches comprenant :

une première couche (2) comprenant du nitrure de silicium ;
une couche comprenant du nitrure de chrome (3) disposée sur le substrat de verre (1) au-dessus de la première couche (2) comprenant du nitrure de silicium ;
une seconde couche (4) comprenant du nitrure de silicium disposée sur le substrat de verre (1) au-dessus de la couche comprenant du nitrure de chrome (3) ;
dans lequel la couche comprenant du nitrure de chrome (3) est prise en sandwich entre, et vient en contact avec, chacune de la première (2) et de la seconde (4) couches comprenant du nitrure de silicium ; et
dans lequel l'article revêtu présente une valeur $\Delta E^*$ (réflectivité côté verre) non supérieure à 3,0 après, et/ou du fait du, traitement thermique ; et
dans lequel la couche comprenant du nitrure de silicium est représentée par $Cr_xN_y$ avec un ratio y/x de N à Cr compris entre 0,25 et 0,7, et elle ne contient pas plus de 10 % environ de Ni.

**2.** L'article revêtu de la revendication 1, dans lequel l'article revêtu présente une valeur $\Delta E^*$ (réflectivité côté verre) non supérieure à 2,0 après, et/ou du fait du, traitement thermique.

**3.** L'article revêtu de la revendication 1, dans lequel le système de couches (5) est essentiellement constitué de la première (2) et de la seconde (4) couches comprenant du nitrure de silicium et de la couche comprenant du nitrure de chrome (3).

4. L'article revêtu de la revendication 1, dans lequel l'article revêtu ne comporte pas de couche métallique réfléchissant l'infrarouge (IR).

5. L'article revêtu de la revendication 1, dans lequel la couche comprenant du nitrure de chrome (3) ne vient en contact avec aucune couche métallique.

6. L'article revêtu de la revendication 1, dans lequel la couche comprenant du nitrure de chrome (3) est formée de manière à pouvoir être nitrurée au moment où elle est déposée.

7. L'article revêtu de la revendication 1, dans lequel l'article revêtu est une unité de fenêtre à vitrage isolant, une fenêtre monolithique ou une fenêtre laminée.

8. L'article revêtu de la revendication 1, dans lequel ledit nitrure de chrome est **caractérisé par** $Cr_xN_y$, avec y/x compris entre 0,3 et 0,6.

9. L'article revêtu de la revendication 1, dans lequel ledit nitrure de chrome est **caractérisé par** $Cr_xN_y$, avec y/x compris entre 0,45 et 0,55.

10. L'article revêtu de la revendication 1, dans lequel ladite couche comprenant du nitrure de chrome (3) comprend environ 55 à 90 % de chrome en pourcentage atomique, et environ 15 à 50 % d'azote en pourcentage atomique.

11. Un procédé de fabrication d'un article revêtu, ce procédé comprenant :

   la pulvérisation cathodique d'une première couche diélectrique de nitrure de silicium sur un substrat ;
   la pulvérisation cathodique d'une couche comprenant du nitrure de chrome sur le substrat au-dessus de la première couche diélectrique ;
   la pulvérisation cathodique d'une seconde couche diélectrique de nitrure de silicium sur le substrat au-dessus de la couche comprenant du nitrure de chrome ; et
   dans lequel la couche comprenant du nitrure de chrome fait l'objet d'une pulvérisation cathodique de manière à former $Cr_xN_y$ avec y/x compris entre 0,25 et 0,7, et elle ne contient pas plus de 10 % environ de Ni.

12. Le procédé de la revendication 11, comprenant en outre le traitement thermique de l'article revêtu à une (des) température(s) d'au moins 580 à 600˚C, de sorte que l'article revêtu présente une valeur $\Delta E^*$ (valeur de réflectivité et/ou de transmissivité côté verre) non supérieure à 3,0 du fait du traitement thermique.

Fig. 1

Fig. 2

## Fig. 3

**CrNx Layer Stoichiometry versus %N2 during deposition**
Ar flow 45 sccm, power 1 kW, ILS coater

## Fig. 4

**Nitrogen to Chromium Ratio in CrNx Film versus % N2 flow**
Ar flow 45 sccm, power 1 kW, ILS coater

**Nitrogen to Chromium Ratio in the CrNx Filmversus N2 flow**
Ar flow 45 sccm, power 1 kW, ILS coater

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5376455 A
- US 5688585 A
- US 5543229 A

**Non-patent literature cited in the description**

- **Hunter.** The Measurement of Appearance. John Wiley & Sons, 1987, 162
- Standard Test Method for Calculation of Color Differences From Instrumentally Measured Color Coordinates. Annual Book of ASTM Standards. vol. 06.01
- Standard Method for Computing the Colors of Objects by 10 Using the CIE System. IES LIGHTING HANDBOOK. 1981